# EUROPÄISCHE PATENTANMELDUNG

(11) **EP 4 675 395 A1**
(43) Veröffentlichungstag der Anmeldung: **07.01.2026**
(21) Anmeldenummer: 24186202.8
(22) Anmeldetag: 03.07.2024
(51) Int. Cl.: G06F 1/18, G06F 1/20, H05K 5/02

(54) **WECHSELBARE HARDWAREKOMPONENTE UND DATENVERARBEITUNGSEINRICHTUNG**

(71) Anmelder: Siemens Aktiengesellschaft, 80333 München (DE)
(72) Erfinder: Scheibl, Markus, 92263 Ebermansdorf (DE)
(74) Vertreter: Siemens Patent Attorneys

(57) **Zusammenfassung**

Die Erfindung betrifft eine wechselbare Hardwarekomponente (100), insbesondere SSD-Massenspeicher, umfassend ein Komponentengehäuse (110), das einen Grundkörper (111) und einen mit dem Grundkörper (111) verbindbaren Gehäusedeckel (117) aufweist, und eine in dem Komponentengehäuse 110) auf einer Leiterplatte (121) angeordnete elektronische Schaltung (120), wobei die Leiterplatte (121) einen Steckverbinder (123) aufweist, der durch eine Öffnung des Komponentengehäuses (110) von außen zugänglich ist, um den Steckverbinder (123) in einer Einsteckrichtung (214) in einen Stecksockel (213) einer Datenverarbeitungseinrichtung (200) einzuführen, wobei das Komponentengehäuse (110) mindestens zwei einander gegenüberliegende Gleitelemente (112) aufweist, die dazu ausgebildet sind, die Hardwarekomponente (100) entlang von Führungsflächen (215) der Datenverarbeitungseinrichtung (200) formschlüssig in die Datenverarbeitungseinrichtung (200) einzuführen, bis der Steckverbinder (123) in den Stecksockel (213) eingeführt ist.

Die Erfindung betrifft weiterhin eine Datenverarbeitungseinrichtung (200), insbesondere Steuergerät, umfassend ein Gerätegehäuse (210) und eine in dem Gerätegehäuse (210) auf einer Hauptplatine (211) angeordnete elektronische Schaltung (212), wobei die Hauptplatine (211) mindestens einen Stecksockel (213) für eine wechselbare Hardwarekomponente (100) aufweist, der dazu ausgebildet ist, einen Steckverbinder (123) der wechselbaren Hardwarekomponente (100) in einer Einsteckrichtung (214) in den Stecksockel (213) einzuführen, wobei mindestens zwei einander gegenüberliegende, sich parallel zu der Einsteckrichtung (214) erstreckende Führungsflächen (215) vorgesehen sind, die dazu ausgebildet sind, Gleitelemente (112) der wechselbaren Hardwarekomponente (100) entlang der Führungsflächen (215) formschlüssig in die Datenverarbeitungseinrichtung (200) einzuführen, bis der Steckverbinder (123) in den Stecksockel (213) eingeführt ist.

## Beschreibung

Die Erfindung betrifft eine wechselbare Hardwarekomponente, insbesondere einen wechselbaren Halbleiter-Massenspeicher, und eine Datenverarbeitungseinrichtung, insbesondere ein Steuergerät, mit einer solchen Hardwarekomponente.

Unter einer Datenverarbeitungseinrichtung werden Geräte und Einrichtungen zur elektronischen Datenverarbeitung im weitesten Sinne verstanden, d.h. Einrichtungen, in denen Daten wie Betriebssysteme, Anwendungsprogramme, Messwertdaten und dergleichen ausgeführt, erfasst, rechentechnisch verarbeitet, gespeichert, ausgegeben, usw. werden.

Datenverarbeitungseinrichtungen in diesem Sinne können beispielsweise Universalgeräte wie Personal Computer oder Spezialgeräte wie Steuergeräte sein. Unter einem Steuergerät wird hier vornehmlich ein Gerät verstanden, das zur automatischen Steuerung und/oder Regelung von Maschinen, Anlagen und technischen Prozessen eingerichtet ist. Steuergeräte sind beispielsweise Automatisierungsgeräte, industrielle loT-Geräte (loT: Internet of Things, deutsch: Internet der Dinge) und speicherprogrammierbare Steuerungen (englisch: Programmable Logic Controller).

Datenverarbeitungseinrichtungen sind üblicherweise aus verschiedenen Komponenten wie einem Gerätegehäuse, einer Hauptplatine, einem Prozessor, einem Arbeitsspeicher, einem Massenspeicher usw. aufgebaut. Außerdem sind Datenverarbeitungseinrichtungen meist modular durch wechselbare Hardwarekomponenten erweiterbar. Beispiele für wechselbare Hardwarekomponenten sind Netzwerkkarten, Grafikkarten, Massenspeicher wie Festplattenlaufwerke (engl. Hard Disk Drive, HDD) oder Halbleiterlaufwerke (engl. Solid State Drive, SSD) usw..

Auf dem Gebiet der Massenspeicher haben SSD-Massenspeicher inzwischen HDD-Massenspeicher fast vollständig verdrängt. Sie bestehen aus Speicher- und Controllerchips, die auf einer Leiterplatte angeordnet sind. Die Leiterplatte weist dabei üblicherweise einen direkten Steckverbinder in Form eines Platinensteckers (auch "Randstecker", "Kantensteckverbinder", englisch "edge connector" genannt) auf. Ein Platinenstecker ist ein Stecker, der durch Kupferflächen im Randbereich der Leiterplatte gebildet wird. Die Montage eines SSD-Massenspeichers erfolgt üblicherweise dadurch, dass die Leiterplatte des SSD-Massenspeichers mit ihrem Steckverbinder in einen auf oder an einer Hauptplatine der Datenverarbeitungseinrichtung angeordneten Stecksockel (auch "Steckplatz", "Buchse", englisch "socket" genannt) eingesteckt und - oft mittels einer Befestigungsschraube - an der Hauptplatine der Datenverarbeitungseinrichtung fixiert wird. Im montierten Zustand erstreckt sich dann die Leiterplatte der wechselbaren Hardwarekomponente parallel zu der Hauptplatine der Datenverarbeitungseinrichtung.

Soll nun eine solche wechselbare Hardwarekomponente, beispielsweise ein SSD-Massenspeicher ausgetauscht oder ersetzt werden, so muss in aller Regel das Gerätegehäuse der Datenverarbeitungseinrichtung geöffnet, die Befestigungsschraube entfernt und die Leiterplatte aus dem Stecksockel entfernt werden. Dies ist mit hohem Aufwand verbunden. Insbesondere bei Steuergeräten kann es überdies notwendig sein, das Steuergerät aus einem komplexeren Aufbau, beispielsweise einem Schaltschrank, zu entfernen, bevor ein Austausch der Komponente erfolgen kann. Schließlich ist es bei dem beschriebenen Typ einer wechselbaren Hardwarekomponente kaum möglich, einen Austausch im laufenden Betrieb der Datenverarbeitungseinrichtung durchzuführen.

Eine Aufgabe der Erfindung besteht darin, eine wechselbare Hardwarekomponente und eine Datenverarbeitungseinrichtung anzugeben, mit denen die beschriebenen Nachteile des Standes der Technik überwunden werden können. Insbesondere soll eine wechselbare Hardwarekomponente auf einfache Weise schnell gewechselt werden können.

Die Aufgabe wird erfindungsgemäß durch eine wechselbare Hardwarekomponente mit den Merkmalen des Anspruchs 1 und eine Datenverarbeitungseinrichtung mit den Merkmalen des Anspruchs 6 gelöst.

Vorteilhafte Ausgestaltungen der Erfindung sind Gegenstand der Unteransprüche.

Vorgeschlagen wird zunächst eine wechselbare Hardwarekomponente, insbesondere ein SSD-Massenspeicher, die ein Komponentengehäuse, das einen Grundkörper und einen mit dem Grundkörper verbindbaren Gehäusedeckel aufweist, und eine in dem Komponentengehäuse auf einer Leiterplatte angeordnete elektronische Schaltung umfasst, wobei die Leiterplatte einen Steckverbinder aufweist, der durch eine Öffnung des Komponentengehäuses von außen zugänglich ist, um den Steckverbinder in einer Einsteckrichtung in einen Stecksockel einer Datenverarbeitungseinrichtung einzuführen, wobei das Komponentengehäuse mindestens zwei einander gegenüberliegende Gleitelemente aufweist, die dazu ausgebildet sind, die Hardwarekomponente entlang von Führungsflächen der Datenverarbeitungseinrichtung formschlüssig in die Datenverarbeitungseinrichtung einzuführen, bis der Steckverbinder in den Stecksockel eingeführt ist.

Die erfindungsgemäße Anordnung in einem Komponentengehäuse mit Gleitelementen, die dazu ausgebildet sind, die Hardwarekomponente formschlüssig in die Datenverarbeitungseinrichtung einzuführen, schafft die Voraussetzung dafür, beispielsweise einen SSD-Massenspeicher schnell und einfach aus einer dafür eingerichteten Datenverarbeitungseinrichtung zu entnehmen und ebenso schnell und einfach einen anderen SSD-Massenspeicher an derselben Stelle in der Datenverarbeitungseinrichtung zu installieren.

Beispielsweise können die Gleitelemente der wechselbaren Hardwarekomponente durch Seitenflächen des Komponentengehäuses gebildet sein, die entlang der Führungsflächen gleiten. Vorteilhaft können die Gleitelemente der wechselbaren Hardwarekomponente beispielsweise als auswärts ragende Nasen ausgeführt sein, die die Führungsflächen der Datenverarbeitungseinrichtung nur punktuell berühren, um einen geringen Reibungswiderstand zu erzielen. Alternativ oder zusätzlich kann vorgesehen sein, dass die Gleitelemente jeweils eine sich parallel zu der Einsteckrichtung erstreckende Gleitfläche aufweisen. Mit anderen Worten können die Gleitelemente der wechselbaren Hardwarekomponente auswärts ragende Nasen sein, die ebene Flächenelemente aufweisen, welche parallel zu den Führungsflächen der Datenverarbeitungseinrichtung verlaufen, um eine bessere seitliche Führung der wechselbaren Hardwarekomponente zu erzielen.

In einer Ausgestaltung kann vorgesehen sein, dass das Komponentengehäuse an einer dem Steckverbinder gegenüberliegenden Seite ein Verbindungselement aufweist, das dazu ausgebildet ist, mit einem korrespondierenden Verbindungselement der Datenverarbeitungseinrichtung lösbar verbunden zu werden. In einer einfachen Ausführung kann das Komponentengehäuse als Verbindungselement eine Durchgangsbohrung aufweisen. Die Durchgangsbohrung kann beispielsweise an einer Lasche des Komponentengehäuses angeordnet sein. Ist an der Datenverarbeitungseinrichtung, beispielsweise an dem Gerätegehäuse der Datenverarbeitungseinrichtung, als korrespondierendes Verbindungselement eine Gewindebohrung vorgesehen, so kann die wechselbare Komponente auf einfache Weise mit dem Gerätegehäuse verbunden werden, indem eine Befestigungsschraube durch die Durchgangsbohrung gesteckt und in die Gewindebohrung eingeschraubt wird.

In einer weiteren Ausgestaltung der wechselbaren Hardwarekomponente kann vorgesehen sein, dass das Komponentengehäuse an einer dem Steckverbinder gegenüberliegenden Seite ein Handhabungselement aufweist, das dazu ausgebildet ist, die Hardwarekomponente zu greifen und in die Datenverarbeitungseinrichtung einzuführen oder aus der Datenverarbeitungseinrichtung herauszuziehen. Ein solches Handhabungselement kann beispielsweise als ein Griff oder Knopf oder Bügel ausgebildet sein, der die Montage und Demontage der wechselbaren Hardwarekomponente dadurch erleichtert, dass er das Ergreifen der Hardwarekomponente ermöglicht. Um ein platzsparendes Handhabungselement zu realisieren kann dieses beispielsweise gelenkig an dem Komponentengehäuse befestigt sein, so dass es sich an das Komponentengehäuse anlegt, wenn es nicht gebraucht wird.

In bestimmten Ausgestaltungen der wechselbaren Hardwarekomponente enthält die elektronische Schaltung mindestens eine wärmeerzeugende Elektronikkomponente. Bei einem hoch beanspruchten SSD-Massenspeicher können sich beispielsweise die Speicherchips stark erwärmen. Gemäß einer vorteilhaften Ausgestaltung der wechselbaren Hardwarekomponente kann daher vorgesehen sein, dass der Gehäusedeckel als Kühlkörper ausgebildet ist, der mit der mindestens einen wärmeerzeugenden Elektronikkomponente wärmeleitend verbunden ist, wenn der Gehäusedeckel mit dem Grundkörper verbunden ist. Ein Kühlkörper kann dabei ein Festkörper aus einem gut wärmeleitfähigen Material wie Aluminium oder dergleichen sein, der eine künstlich, beispielsweise durch Kühlrippen, vergrößerte Oberfläche aufweist.

Weiterhin wird eine Datenverarbeitungseinrichtung, insbesondere ein Steuergerät, vorgeschlagen, die ein Gerätegehäuse und eine in dem Gerätegehäuse auf einer Hauptplatine angeordnete elektronische Schaltung umfasst, wobei die Hauptplatine mindestens einen Stecksockel für eine wechselbare Hardwarekomponente aufweist, der dazu ausgebildet ist, einen Steckverbinder der wechselbaren Hardwarekomponente in einer Einsteckrichtung in den Stecksockel einzuführen, wobei mindestens zwei einander gegenüberliegende, sich parallel zu der Einsteckrichtung erstreckende Führungsflächen vorgesehen sind, die dazu ausgebildet sind, Gleitelemente der wechselbaren Hardwarekomponente entlang der Führungsflächen formschlüssig in die Datenverarbeitungseinrichtung einzuführen, bis der Steckverbinder in den Stecksockel eingeführt ist. Die Führungsflächen können beispielsweise durch eine separate Komponente gebildet sein, die im Innern des Gerätegehäuses angeordnet ist. Besonders vorteilhaft können die Führungsflächen direkt am Gerätegehäuse ausgebildet sein.

Die vorgeschlagene Datenverarbeitungseinrichtung ist durch die auf den Stecksockel der Hauptplatine zulaufenden Führungsflächen dafür ausgebildet, den einfachen Austausch einer wechselbaren Hardwarekomponente zu ermöglichen, indem Gleitelemente der wechselbaren Hardwarekomponente so zwangsgeführt werden, dass der Steckverbinder unabwendbar in den Stecksockel der Datenverarbeitungseinrichtung eingeführt wird. Das Einstecken des Steckverbinders kann zusätzlich dadurch erleichtert sein, dass die Einsteckrichtung senkrecht zur Ebene der Hauptplatine verläuft. Mit anderen Worten kann weiterhin vorgesehen sein, dass die Leiterplatte der wechselbaren Hardwarekomponente im montierten Zustand senkrecht zur Hauptplatine der Datenverarbeitungseinrichtung steht. Dadurch ergeben sich auch hinsichtlich der Wärmeabfuhr von der wechselbaren Hardwarekomponente weitere Vorteile, weil die wechselbare Hardwarekomponente allseitig von Kühlluft umströmt werden kann.

In einer besonders vorteilhaften Ausgestaltung der vorgeschlagenen Datenverarbeitungseinrichtung kann vorgesehen sein, dass das Gerätegehäuse mindestens eine einem Stecksockel gegenüberliegend angeordnete Öffnung aufweist, die zum Einführen einer wechselbaren Hardwarekomponente ausgebildet ist, wobei die Führungsflächen zwischen der Öffnung und dem Stecksockel angeordnet sind. Weist die Datenverarbeitungseinrichtung in der beschriebenen Art und Weise eine Öffnung auf, so wird es besonders einfach, die wechselbare Hardwarekomponente auszutauschen. Die wechselbare Hardwarekomponente wird durch die Öffnung des Gerätegehäuses in die Datenverarbeitungseinrichtung eingeführt. Durch die an die Öffnung entweder direkt oder mit einem Abstand zur Öffnung anschließenden Führungsflächen wird die wechselbare Hardwarekomponente weiter in die Datenverarbeitungseinrichtung hinein und auf den Stecksockel geführt. Wenn die wechselbare Hardwarekomponente mit ihrem Steckverbinder den Stecksockel auf der Hauptplatine erreicht, taucht der Steckverbinder in den Stecksockel ein und anschließend sind die Hauptplatine der Datenverarbeitungseinrichtung und die Leiterplatte der wechselbaren Hardwarekomponente elektrisch und datenleitend miteinander verbunden.

In einer weiteren Ausgestaltung kann vorgesehen sein, dass das Gerätegehäuse im Bereich der Öffnung, d.h. direkt an der Öffnung oder mit einem gewissen Abstand hinter der Öffnung, beispielsweise am Anfang einer Führungsfläche, ein Verbindungselement aufweist, das dazu ausgebildet ist, mit einem korrespondierenden Verbindungselement der wechselbaren Hardwarekomponente lösbar verbunden zu werden.

In einer einfachen Ausführung kann das Gerätegehäuse als Verbindungselement eine Rastnut aufweisen. Die Rastnut kann beispielsweise an einer Führungsfläche des Gerätegehäuses angeordnet sein. Ist an der wechselbaren Hardwarekomponente, beispielsweise an dem Komponentengehäuse, als korrespondierendes Verbindungselement eine elastische Rastnase vorgesehen, so kann die wechselbare Komponente auf einfache Weise mit dem Gerätegehäuse verbunden werden, indem die Rastnase der wechselbaren Hardwarekomponente in die Rastnut des Gerätegehäuses eingerastet wird. Ebenso ist es möglich, dass das Gerätegehäuse der Datenverarbeitungseinrichtung eine elastische Rastnase aufweist und das Komponentengehäuse der wechselbaren Hardwarekomponente eine mit dieser Rastnase korrespondierende Rastnut aufweist.

In einer vorteilhaften Weiterbildung der vorgeschlagenen Datenverarbeitungseinrichtung kann vorgesehen sein, dass das Gerätegehäuse im Bereich der Öffnung ein Verschlusselement aufweist, das dazu ausgebildet ist, die Öffnung wahlweise freizugeben oder zu verschließen. Wird der hinter der Öffnung liegende Steckplatz nicht für eine Hardwarekomponente benötigt, so kann das Verschlusselement, das beispielsweise gelenkig an dem Gerätegehäuse angebracht sein kann, verschlossen werden, um das Eindringen von Staub in die Datenverarbeitungseinrichtung zu verhindern, die bestimmungsgemäßen Kühlluftströmungen im Innern des Gerätegehäuses nicht zu verfälschen usw. Ist dagegen eine wechselbare Hardwarekomponente in dem hinter der Öffnung liegenden Steckplatz angeordnet, so kann das Verschlusselement ebenfalls verschlossen werden, um die wechselbare Hardwarekomponente vor unbeabsichtigter oder unbefugter Manipulation zu schützen. Dazu kann besonders vorteilhaft weiterhin vorgesehen sein, dass das Verschlusselement abschließbar ist, d.h. dass ein Schlüssel benötigt wird, um das Verschlusselement zu öffnen und den Zugriff auf die wechselbare Hardwarekomponente zu ermöglichen.

Die oben beschriebenen Eigenschaften, Merkmale und Vorteile dieser Erfindung sowie die Art und Weise, wie diese erreicht werden, werden klarer und deutlicher verständlich im Zusammenhang mit der folgenden Beschreibung von Ausführungsbeispielen, die im Zusammenhang mit den Zeichnungen näher erläutert werden. Dabei zeigen:
- FIG 1: eine Explosionsdarstellung eines Ausführungsbeispiels einer wechselbaren Hardwarekom ponente,
- FIG 2: eine Zusammenbauzeichnung des Ausführungsbeispiels aus Fig. 1,
- FIG 3: eine perspektivische Teilansicht eines Ausführungsbeispiels einer Datenverarbeitungseinrichtung, und
- FIG 4: eine Schnittdarstellung des Ausführungsbeispiels aus Fig. 3.

Einander entsprechende Teile sind in den Figuren mit denselben Bezugszeichen versehen.

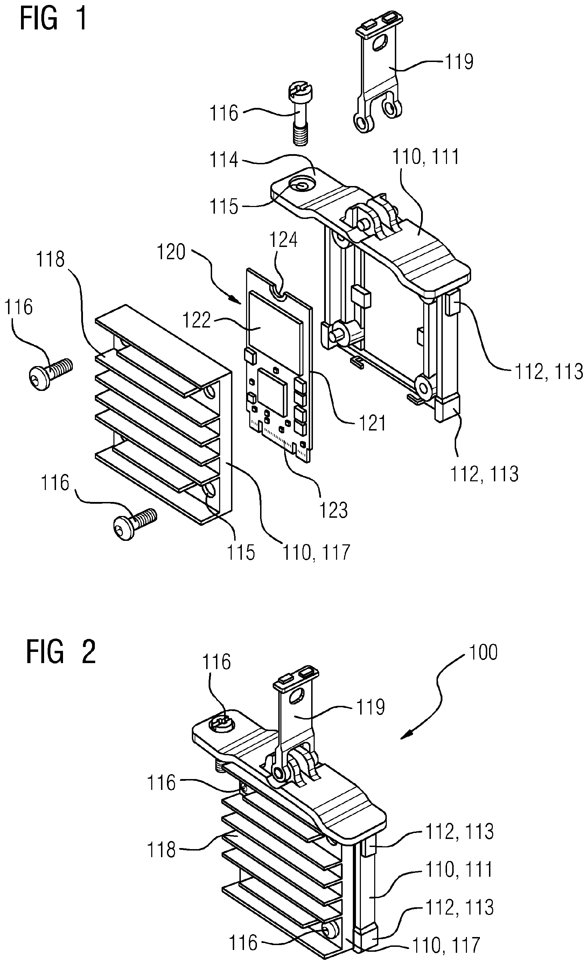

Die Darstellungen der Fig. 1 und 2 zeigen dasselbe Ausführungsbeispiel einer erfindungsgemäßen wechselbaren Hardwarekomponente 100. Konkret handelt es sich dabei um einen erfindungsgemäß ausgestalteten wechselbaren SSD-Massenspeicher.

Wie insbesondere aus der Explosionsdarstellung der Fig. 1 erkennbar ist, befindet sich im Innern der wechselbaren Hardwarekomponente 100 eine elektronische Schaltung 120, die eine Leiterplatte 121 mit darauf angeordneten Elektronikkomponenten 122, nämlich Speicher- und Controllerchips, umfasst. Zur Herstellung einer datenleitenden Verbindung weist die Leiterplatte121 an einem Rand einen Steckverbinder 123 auf. Am gegenüberliegenden Rand der Leiterplatte 121 ist eine Befestigungskerbe 124 angeordnet, die dazu dient, die Leiterplatte 121 mittels einer (hier nicht dargestellten) Befestigungsschraube 116 an einer Trägerstruktur zu fixieren.

Erfindungsgemäß ist diese Trägerstruktur jedoch nicht mehr die Hauptplatine 211 eines übergeordneten Geräts, dessen Funktionalität durch die elektronische Schaltung 120 erweitert werden soll. Stattdessen wird die elektronische Schaltung 120 erfindungsgemäß dadurch schnell und einfach austauschbar, dass sie in einem Komponentengehäuse 110 angeordnet ist. Das Komponentengehäuse 110 ist zusammengesetzt aus einem Grundkörper 111 sowie einem mit dem Grundkörper 111 durch zwei Befestigungsschrauben 116 verbundenen Gehäusedeckel 117.

Wenn der Grundkörper 111 und der Gehäusedeckel 117 miteinander zu dem Komponentengehäuse 110 verbunden sind, bilden der Grundkörper 111 und der Gehäusedeckel 117 eine Öffnung des Komponentengehäuses 110, durch die der Steckverbinder 123 der Leiterplatte 121 von außen zugänglich ist.

Der Gehäusedeckel 117 weist Kühlrippen auf und wirkt daher als Kühlkörper 118 für die elektronische Schaltung 120, namentlich für die wärmeerzeugenden Elektronikkomponenten 122 der elektronischen Schaltung 120. Diese Funktion wird dadurch erreicht, dass der Gehäusedeckel 117 im montierten Zustand direkt auf der oder den wärmeerzeugenden Elektronikkomponenten 122 aufliegt. Zur Verbesserung der Wärmeleitung von der Elektronikkomponente 122 zum Kühlkörper 118 kann vorteilhaft vor der Montage des Gehäuses 110 eine (hier nicht dargestellte) Wärmleitpaste auf die Oberfläche der Elektronikkomponente 122 aufgetragen werden.

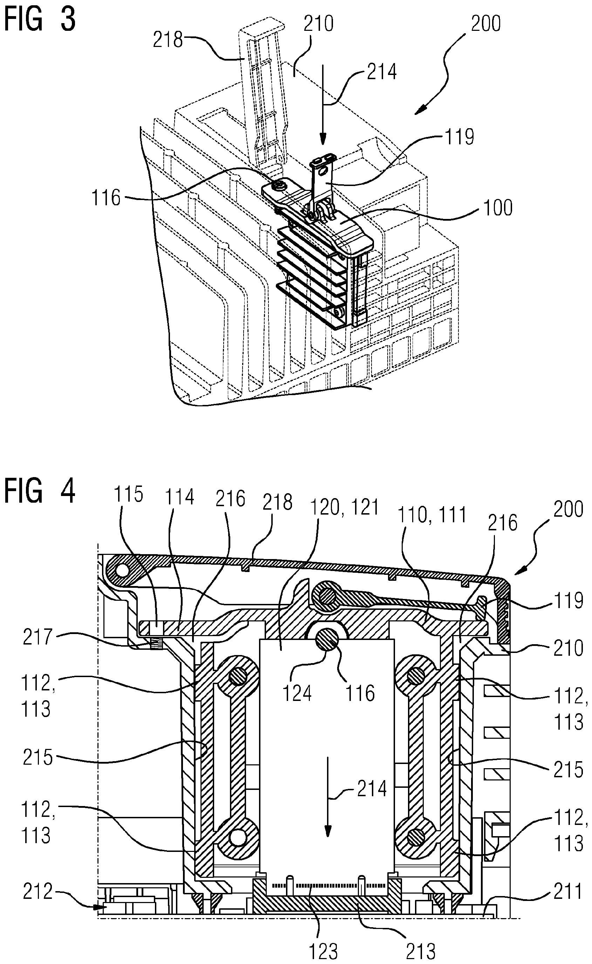

Der Grundkörper 111 des Komponentengehäuses 110 weist an zwei gegenüberliegenden Schmalseiten, die rechtwinklig zu dem Steckverbinder 123 der Leiterplatte 121 verlaufen, je zwei Gleitelemente 112 auf. In der gewählten Darstellung ist nur eine der beiden betroffenen Schmalseiten zu sehen, an der zwei Gleitelemente 112 angeordnet sind. Die Gleitelemente 112 sind dazu ausgebildet, die Hardwarekomponente 100 formschlüssig in eine Datenverarbeitungseinrichtung 200 einzuführen, wie nachfolgend mit Bezug zu Fig. 3 und 4 noch näher erläutert wird.

Die Gleitelemente 112 sind als auswärts, d.h. vom Komponentengehäuse 110 weg, ragende Nasen ausgebildet. Darüber hinaus weisen sie je eine sich rechtwinklig zu dem Steckverbinder 123 der Leiterplatte 121 erstreckende Gleitfläche 113 auf.

An einer dem Steckverbinder 123 gegenüberliegenden Seite weist das Komponentengehäuse 110 eine Lasche 114 mit einem Verbindungselement 115 auf, das im Ausführungsbeispiel als Durchgangsbohrung 115 ausgeführt ist und das dazu dient, mit einer Datenverarbeitungseinrichtung 200 lösbar verbunden zu werden.

Weiterhin weist das Komponentengehäuse 110 an der dem Steckverbinder 123 gegenüberliegenden Seite ein Handhabungselement 119 in Form eines gelenkig gelagerten und daher anklappbaren Handgriffs auf. Mittels des Handgriffs 119 kann die Hardwarekomponente 100 ergriffen und in die Datenverarbeitungseinrichtung 200 eingeführt oder aus der Datenverarbeitungseinrichtung 200 herausgezogen werden.

Fig. 3 und 4 zeigen, wie die wechselbare Hardwarekomponente 100 aus den Fig. 1 und 2 in einer Datenverarbeitungseinrichtung 200 positioniert wird.

Die Datenverarbeitungseinrichtung 200 weist ein Gerätegehäuse 210 auf, in dem eine Hauptplatine 211 angeordnet ist, die eine elektronische Schaltung 212 trägt. Auf der Hauptplatine 211 ist auch ein Stecksockel 213 für eine wechselbare Hardwarekomponente 100 so angeordnet, dass ein Steckverbinder 123 der wechselbaren Hardwarekomponente 100 in einer rechtwinklig zu der Hauptplatine 211 verlaufenden Einsteckrichtung 214 in den Stecksockel 213 eingeführt werden kann. Hierzu weist das Gerätegehäuse 210 eine dem Stecksockel 213 gegenüberliegende angeordnete Öffnung 216 auf.

Die Öffnung 216 ist hinsichtlich ihrer Größe und ihrer Anordnung relativ zum Stecksockel 213 zum Einführen einer wechselbaren Hardwarekomponente 100 ausgebildet. Im Innern des Gerätegehäuses 210, d. h. hinter der Öffnung 216, erstrecken sich zwei einander gegenüberliegende Führungsflächen 215 parallel zu der Einsteckrichtung 214.

Die Führungsflächen 215 sind am Gerätegehäuse 210 angeordnet und sie sind dazu ausgebildet, die Gleitelemente 112 der wechselbaren Hardwarekomponente 100 formschlüssig in die Datenverarbeitungseinrichtung 200 einzuführen, bis der Steckverbinder 123 in den Stecksockel 213 eingeführt ist. Dazu erstrecken sich die Führungsflächen 215 zwischen der Öffnung 216 und dem Stecksockel 213.

Im Bereich der Öffnung 216 weist das Gerätegehäuse 210 ein Verbindungselement 217 in Form einer Gewindebohrung 217 auf. Diese Gewindebohrung 217 ist dazu vorgesehen, die wechselbare Hardwarekomponente 100 am Gerätegehäuse 210 der Datenverarbeitungseinrichtung 200 zu fixieren, indem eine Befestigungsschraube 116 durch die Durchgangsbohrung 115 in der Lasche 114 der wechselbaren Hardwarekomponente 100 hindurch in die Gewindebohrung 217 des Gerätegehäuses 210 eingeschraubt wird.

Weiterhin weist das Gerätegehäuse 210 im Bereich der Öffnung 216 ein gelenkig befestigtes Verschlusselement 218 auf, das dazu ausgebildet ist, die Öffnung 216 wahlweise freizugeben oder zu verschließen. Um dies zu ermöglichen, ist das Handhabungselement 119 der wechselbaren Hardwarekomponente 100 ebenfalls gelenkig befestigt und kann daher platzsparend angeklappt werden.

Obwohl die Erfindung im Detail durch bevorzugte Ausführungsbeispiele näher illustriert und beschrieben wurde, so ist die Erfindung nicht durch die offenbarten Beispiele eingeschränkt und andere Variationen können vom Fachmann hieraus abgeleitet werden, ohne den Schutzumfang der Erfindung zu verlassen.

Unabhängig vom grammatikalischen Geschlecht eines bestimmten Begriffes sind Personen mit männlicher, weiblicher oder anderer Geschlechteridentität mit umfasst.

## Patentansprüche

1. Wechselbare Hardwarekomponente (100), insbesondere SSD-Massenspeicher, umfassend ein Komponentengehäuse (110), das einen Grundkörper (111) und einen mit dem Grundkörper (111) verbindbaren Gehäusedeckel (117) aufweist, und eine in dem Komponentengehäuse 110) auf einer Leiterplatte (121) angeordnete elektronische Schaltung (120), wobei die Leiterplatte (121) einen Steckverbinder (123) aufweist, der durch eine Öffnung des Komponentengehäuses (110) von außen zugänglich ist, um den Steckverbinder (123) in einer Einsteckrichtung (214) in einen Stecksockel (213) einer Datenverarbeitungseinrichtung (200) einzuführen, wobei das Komponentengehäuse (110) mindestens zwei einander gegenüberliegende Gleitelemente (112) aufweist, die dazu ausgebildet sind, die Hardwarekomponente (100) entlang von Führungsflächen (215) der Datenverarbeitungseinrichtung (200) formschlüssig in die Datenverarbeitungseinrichtung (200) einzuführen, bis der Steckverbinder (123) in den Stecksockel (213) eingeführt ist.

2. Wechselbare Hardwarekomponente (100) nach Anspruch 1, wobei die Gleitelemente (112) als auswärts ragende Nasen ausgebildet sind oder/und jeweils eine sich parallel zu der Einsteckrichtung (214) erstreckende Gleitfläche (113) aufweisen.

3. Wechselbare Hardwarekomponente (100) nach Anspruch 1 oder 2, wobei das Komponentengehäuse (110) an einer dem Steckverbinder (123) gegenüberliegenden Seite ein Verbindungselement (115) aufweist, das dazu ausgebildet ist, mit einem korrespondierenden Verbindungselement (217) der Datenverarbeitungseinrichtung (200) lösbar verbunden zu werden.

4. Wechselbare Hardwarekomponente (100) nach einem der vorhergehenden Ansprüche, wobei das Komponentengehäuse (110) an einer dem Steckverbinder (123) gegenüberliegenden Seite ein Handhabungselement (119) aufweist, das dazu ausgebildet ist, die Hardwarekomponente (100) zu greifen und in die Datenverarbeitungseinrichtung (200) einzuführen oder aus der Datenverarbeitungseinrichtung (200) herauszuziehen.

5. Wechselbare Hardwarekomponente (100) nach einem der vorhergehenden Ansprüche, wobei die elektronische Schaltung (120) mindestens eine wärmeerzeugende Elektronikkomponente (122) aufweist und der Gehäusedeckel (117) als Kühlkörper (118) ausgebildet ist, der mit der mindestens einen wärmeerzeugenden Elektronikkomponente (122) wärmeleitend verbunden ist, wenn der Gehäusedeckel (117) mit dem Grundkörper (111) verbunden ist.

6. Datenverarbeitungseinrichtung (200), insbesondere Steuergerät, umfassend ein Gerätegehäuse (210) und eine in dem Gerätegehäuse (210) auf einer Hauptplatine (211) angeordnete elektronische Schaltung (212), wobei die Hauptplatine (211) mindestens einen Stecksockel (213) für eine wechselbare Hardwarekomponente (100) aufweist, der dazu ausgebildet ist, einen Steckverbinder (123) der wechselbaren Hardwarekomponente (100) in einer Einsteckrichtung (214) in den Stecksockel (213) einzuführen, wobei mindestens zwei einander gegenüberliegende, sich parallel zu der Einsteckrichtung (214) erstreckende Führungsflächen (215) vorgesehen sind, die dazu ausgebildet sind, Gleitelemente (112) der wechselbaren Hardwarekomponente (100) entlang der Führungsflächen (215) formschlüssig in die Datenverarbeitungseinrichtung (200) einzuführen, bis der Steckverbinder (123) in den Stecksockel (213) eingeführt ist.

7. Datenverarbeitungseinrichtung (200) nach Anspruch 6, wobei die Führungsflächen (215) am Gerätegehäuse (210) ausgebildet sind.

8. Datenverarbeitungseinrichtung (200) nach Anspruch 6 oder 7, wobei das Gerätegehäuse (210) mindestens eine einem Stecksockel (213) gegenüberliegend angeordnete Öffnung (216) aufweist, die zum Einführen einer wechselbaren Hardwarekomponente (100) ausgebildet ist, wobei die Führungsflächen (215) zwischen der Öffnung (216) und dem Stecksockel (213) angeordnet sind.

9. Datenverarbeitungseinrichtung (200) nach Anspruch 8, wobei das Gerätegehäuse (210) im Bereich der Öffnung (216) ein Verbindungselement (217) aufweist, das dazu ausgebildet ist, mit einem korrespondierenden Verbindungselement (115) der wechselbaren Hardwarekomponente (100) lösbar verbunden zu werden.

10. Datenverarbeitungseinrichtung (200) nach Anspruch 8 oder 9, wobei das Gerätegehäuse (210) im Bereich der Öffnung (216) ein Verschlusselement (218) aufweist, das dazu ausgebildet ist, die Öffnung (216) wahlweise freizugeben oder zu verschließen.

11. Datenverarbeitungseinrichtung (200) nach Anspruch 10, wobei das Verschlusselement (218) abschließbar ist.
